# EUROPEAN PATENT APPLICATION

(11) **EP 3 862 379 A1**
(43) Date of publication of application: **11.08.2021**
(21) Application number: 19870012.2
(22) Date of filing: 02.10.2019
(51) Int. Cl.: C08J 5/00, C08K 7/04, C08L 23/12, C08L 101/00

(54) **RESIN MOLDED BODY**

(30) Priority: 05.10.2018 JP 2018190124
(71) Applicant: Daicel Miraizu Ltd., Tokyo 108-8231 (JP)
(72) Inventor: KATAYAMA, Hiroshi, Tokyo 108-8231 (JP); UEDA, Takafumi, Tokyo 108-8230 (JP)
(74) Representative: Grünecker Patent- und Rechtsanwälte PartG mbB
(86) International application number: PCT/JP2019/038898
(87) International publication number: WO 2020/071421

(57) **Abstract**

A resin molded body obtained from a resin composition containing a thermoplastic resin (A), a flame retardant (B), and a metal fiber (C). The resin molded body contains from 15 to 30 mass% of the flame retardant (B) and from 2.5 to 7.5 mass% of the metal fiber (C), with the remainder being component (A) to make a total of 100 mass%. The resin molded body has a determination result of V-0 or V-1 in a burning test using the UL 94 V test method on a test piece having a thickness of 1.5 mm. The resin molded body satisfies the requirements described in the following (I) to (IV). (I) A thickness of the resin molded body is from 1.5 to 8.0 mm. (II) The resin molded body self-extinguishes within five minutes after the completion of a burning test using burning test method E as described below. (III) The resin molded body does not have a hole after being subjected to a burning test using burning test method E as described below. (IV) The resin molded body has an electromagnetic wave shielding property of more than 30 dB using a KEC method electric field in a frequency range from 1 to 100 MHz. Burning test method E: A plaque (150 × 150 × 2.0 mm) made of the molded body described above is used. A 200 mm-long flame is applied from above the plaque directly onto the center of the plaque for 130 seconds. The distance from the flame contact position on the plaque to the burner mouth is 150 mm.

## Description

### Technical Field

According to one embodiment of the present invention, the present invention relates to a resin molded body that can be used in a battery module enclosure part or a peripheral part of a battery-powered electric transportation device, such as an electric vehicle or an electric two-wheeler.

### Background Art

A rechargeable energy storage system (REESS) such as batteries can be found in battery-powered electric transportation devices such as electric vehicles (EVs) and plug-in hybrid vehicles (PHVs). All parts constituting such system are required to have higher flame retardancy and better self-extinguishing property than typical in-vehicle resin parts. For example, the parts must comply with electrical safety regulations, such as ECE-R100 in Europe.

JP 2014-133808 A describes a resin molded body for a charger connector for electric vehicles, a battery capacitor holder, a battery capacitor enclosure, and an enclosure for charging stand for electric vehicles; the resin molded body has a high flame retardancy as well as tracking resistance which ensures safety against fire induced by electrical load. The flame retardant used is a halogen-based flame retardant.

According to "Effect of carbon fiber amount and length on flame retardant and mechanical properties of intumescent polypropylene composites" in the Journal of Composite Materials, 2018, Vol. 52 (4) 519-530, the authors conducted analytical evaluation of the relationship among features (such as length of fiber filament and content) of each component, thermal behavior, and flame retardant effect in a mixture containing polypropylene, carbon fiber, and ammonium polyphosphate; in particular, flame retardancy is required to satisfy V-0 in UL 94.

### Summary of Invention

In one aspect of the present invention, an object is to provide a resin molded body having: flame retardancy that complies with standards required for parts to be installed in a battery-powered electric transportation device; excellent mechanical strength; and electromagnetic wave shielding property.

In one embodiment, the present invention provides a resin molded body obtained from a resin composition containing a thermoplastic resin (A), a flame retardant (B), and a metal fiber (C), wherein the resin molded body contains from 15 to 30 mass% of the flame retardant (B) and from 2.5 to 7.5 mass% of the metal fiber (C), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in the following (I) to (IV).
(I) A thickness of the resin molded body is from 1.5 to 8.0 mm.
(II) The resin molded body self-extinguishes within five minutes after the completion of a burning test using burning test method E as described below.
(III) The resin molded body does not have a hole after being subjected to a burning test using burning test method E as described below.
(IV) The resin molded body has an electromagnetic wave shielding property of more than 30 dB using a KEC method electric field in a frequency range from 1 to 100 MHz.

Burning test method E: A plaque (150 × 150 × 2.0 mm) made of the molded body described above is used. A 200 mm-long flame is applied from above the plaque directly onto the center of the plaque for 130 seconds. The distance from the flame contact position on the plaque to the burner mouth is 150 mm.

In another embodiment, the present invention provides a resin molded body obtained from a resin composition containing a thermoplastic resin (A), a flame retardant (B), a metal fiber (C), and a glass fiber (D), wherein the resin molded body contains from 15 to 30 mass% of the flame retardant (B), from 2.5 to 7.5 mass% of the metal fiber (C), and from 5 to 50 mass% of the glass fiber (D), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in the following (I) to (IV).
(I) A thickness of the resin molded body is from 1.5 to 8.0 mm.
(II) The resin molded body self-extinguishes within five minutes after the completion of a burning test using burning test method E as described below.
(III) The resin molded body does not have a hole after being subjected to a burning test using burning test method E as described below.
(IV) The resin molded body has an electromagnetic wave shielding property of more than 30 dB using a KEC method electric field in a frequency range from 1 to 100 MHz.

Burning test method E: A plaque (150 × 150 × 2.0 mm) made of the molded body described above is used. A 200 mm-long flame is applied from above the plaque directly onto the center of the plaque for 130 seconds. The distance from the flame contact position on the plaque to the burner mouth is 150 mm.

In yet another embodiment, the present invention provides a resin molded body obtained from a resin composition containing a thermoplastic resin (A), a flame retardant (B), a metal fiber (C), a glass fiber (D), and at least one carbonization accelerator (E) selected from the group consisting of magnesium bicarbonate, zinc oxide, titanium oxide, magnesium oxide, and silicon oxide, wherein the resin molded body contains from 15 to 30 mass% of the flame retardant (B), from 2.5 to 7.5 mass% of the metal fiber (C), from 5 to 50 mass% of the glass fiber (D), and from 0.7 to 5.0 mass% of the carbonization accelerator (E), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in the following (I) to (IV).
(I) A thickness of the resin molded body is from 1.5 to 8.0 mm.
(II) The resin molded body self-extinguishes within five minutes after the completion of a burning test using burning test method E as described below.
(III) The resin molded body does not have a hole after being subjected to a burning test using burning test method E as described below.
(IV) The resin molded body has an electromagnetic wave shielding property of more than 30 dB using a KEC method electric field in a frequency range from 1 to 100 MHz.

Burning test method E: A plaque (150 × 150 × 2.0 mm) made of the molded body described above is used. A 200 mm-long flame is applied from above the plaque directly onto the center of the plaque for 130 seconds. The distance from the flame contact position on the plaque to the burner mouth is 150 mm.

In addition to self-extinguishing property that contains a fire when it happens, the resin molded body according to an example of the present invention has flame retardancy that complies with standards required for parts to be installed in a battery-powered electric transportation device (such as the ECE-R100 regulation), good mechanical strength, and good electromagnetic wave shielding property.

### Description of Embodiments

### Resin Composition

Several examples of the resin composition used in the resin molded body according to an embodiment of the present invention will be described below.

### Thermoplastic resin (A)

The thermoplastic resin of component (A) may be, for example, a polyolefin resin. In some examples, a α-C2 to 20 chain olefin resin or a cyclic olefin resin can be used; examples of the α-C2 to 20 chain olefin resin include a polyethylene resin (High Density Polyethylene [HDPE], Low Density Polyethylene [LDPE], Linear Low Density Polyethylene [LLDPE], Very Low Density Polyethylene and Ultra Low Density Polyethylene [VLDPE, ULDPE], etc.), a polypropylene resin, and a methylpentene resin. These polyolefin resins can be used alone or in a combination of two or more. In one embodiment of the present invention, a polypropylene resin is preferably used.

According to some specific examples, the polypropylene resin may be a homopolymer of propylene, or may be a copolymer of propylene and another copolymerizable monomer. Other copolymerizable monomers include, for example: olefin monomers, such as a α-C2 to 20 chain olefin exemplified by ethylene, 1-butene, isobutene, 1-pentene, 4-methyl-1-pentene, and cyclic olefins; vinyl ester-based monomers, such as vinyl acetate and vinyl propionate; (meth)acrylic monomers, for example, (meth)acrylic acid, alkyl (meth)acrylate, vinyl cyanide monomers such as (meth)acrylonitrile; diene monomers such as butadiene; unsaturated polyvalent carboxylic acids or acid anhydrides thereof, such as maleic acid, itaconic acid, citraconic acid or acid anhydrides thereof; imide-based monomers, for example, maleimide and N-substituted maleimides exemplified by N-alkylmaleimides such as N-C1 to 4 alkylmaleimides. These copolymerizable monomers may be used alone or in a combination of two or more.

In some more detailed examples, the polypropylene resin can be: homopolypropylene, which is a homopolymer; or a copolymer, for example, a propylene-α2 to 20 chain olefin copolymer (random copolymer, block copolymer, or the like) having a propylene content of 80 mass% or greater such as a propylene-ethylene copolymer, a propylene-butene-1 copolymer, and a propylene-ethylene-butene-1 copolymer.

Among these polypropylene resins, homopolypropylene and a propylene-α2 to 6 chain olefin copolymer (random copolymer, block copolymer, or the like) are used in a preferred aspect of the present invention; meanwhile, homopolypropylene and a propylene-ethylene copolymer (random copolymer or block copolymer) are used in another preferred aspect of the present invention. These polypropylene resins may be used alone or in a combination of two or more.

### Flame retardant (B)

From the viewpoint of self-extinguishing property after burning test and suppression of hole formation on the molded body, the flame retardant of component (B) in a preferred aspect of the present invention is a phosphorus-based flame retardant; meanwhile, in another preferred aspect of the present invention, the flame retardant of component (B) may be an organic phosphoric acid compound (B-1) or an organic phosphate compound (B-2), or a mixture of the two, and do not contain halogen atoms.

Examples of the organic phosphoric acid compound (B-1) include phosphoric acid, melamine orthophosphate, melamine pyrophosphate, melamine polyphosphate, and melamine phosphate; of these, melamine polyphosphate is preferable, and melamine pyrophosphate is particularly preferable.

Examples of the organic phosphate compound (B-2) include piperazine orthophosphate, piperazine pyrophosphate, and piperazine polyphosphate; of these, piperazine polyphosphate is used in a preferred aspect of the present invention, while piperazine pyrophosphate is used in another preferred aspect of the present invention.

When component (B) is a mixture of component (B-1) and component (B-2), the mass ratio of component (B-1) to component (B-2) is from 1:99 to 99:1 in one preferred aspect of the present invention, from 10:90 to 90:10 in another preferred aspect of the present invention, and from 30:70 to 70:30 in yet another preferred aspect of the present invention. When the mass ratio is within the range from 1:99 to 99:1, the flame retardant effect is good.

Examples of component (B) include commercially available products such as ADK STAB FP-2100JC, FP-2200S, and FP-2500S, all available from ADEKA Corporation.

In a preferred aspect of the present invention, component (B) has an average particle size of 40 µm or less; meanwhile, in another preferred aspect of the present invention, from the perspective of flame retardancy, component (B) may have an average particle size of 10 µm or less. When the average particle size of component (B) is 40 µm or less, dispersibility of component (B) in the thermoplastic resin of component (A) is good, high flame retardancy can be obtained, and the mechanical strength of the resin molded body is also good.

The flame retardant of component (B) may contain known flame retardant aids, foaming agents, or other non-halogen flame retardants as necessary, to the extent that the object of the present invention is not impaired. In some cases, the flame retardant of component (B) may contain a carbonization accelerator corresponding to component (E) as described below.

In a preferred aspect of the present invention, the flame retardant aid may be selected from the group consisting of a condensate of a dimer or higher multimer of pentaerythritol and an ester thereof; in another preferred aspect of the present invention, the flame retardant aid may be one or two or more selected from the group consisting of pentaerythritol and an ester thereof, dipentaerythritol and an ester thereof, and tripentaerythritol and an ester thereof. The flame retardant aid contains, for example, the aforementioned condensate of pentaerythritol as a main component (80 mass% or greater in a preferred aspect of the present invention), with another flame retardant aid taking up the remaining proportion.

Examples of the other flame retardant aid include: polyols, such as pentaerythritol, cellulose, maltose, glucose, arabinose, ethylene glycol, propylene glycol, polyethylene glycol, ethylene-vinyl alcohol copolymers; or an ester compound produced by reacting these polyol components with a carboxylic acid; triazine derivatives, such as melamine, other melamine derivatives, guanamine or other guanamine derivatives, melamine(2,4,6-triamino-1,3,5-triazine), isocyanuric acid, tris(2-hydroxyethyl)isocyanuric acid, tris(hydroxymethyl)isocyanuric acid, tris(3-hydroxypropyl)isocyanurate, and tris(4-hydroxyphenyl)isocyanurate.

In some embodiments of the present invention, examples of the foaming agent may be selected from: melamine, and melamine derivatives such as melamine formaldehyde resin, methylol melamine having from 4 to 9 carbons, and melamine cyanurate; urea, and urea derivatives such as thiourea, (thio)urea-formaldehyde resin, methylol(thio)urea having from 2 to 5 carbons; guanamins such as benzoguanamine, phenylguanamine, acetoguanamine, and succinylguanamine; reaction products of guanamines and formaldehyde; and nitrogen-containing compounds such as dicyandiamide, guanidine, and guanidine sulfamate.

In some embodiments of the present invention, other non-halogen flame retardants include phosphate-based flame retardants, ammonium polyphosphate, red phosphorus, magnesium hydroxide, aluminum hydroxide, and expanded graphite. Examples of the phosphate-based flame retardant include triphenyl phosphate, tricresyl phosphate, trixylenyl phosphate, tris(isopropylphenyl)phosphate, tris(o- or p-phenylphenyl)phosphate, trinaphthyl phosphate, cresyl diphenyl phosphate, xylenyldiphenyl phosphate, diphenyl(2-ethylhexyl)phosphate, di(isopropylphenyl)phenyl phosphate, o-phenylphenyldicresyl phosphate, tris(2,6-dimethylphenyl)phosphate, tetraphenyl-m-phenylene diphosphate, tetraphenyl-p-phenylene diphosphate, phenylresorcin polyphosphate, bisphenol A-bis(diphenyl phosphate), bisphenol A polyphenyl phosphate, and dipyrocatechol hypodiphosphate. In addition, fatty acid or aromatic phosphates, for example, orthophosphates such as diphenyl(2-ethylhexyl)phosphate, diphenyl-2-acryloyloxyethyl phosphate, diphenyl-2-methacryloyloxyethyl phosphate, phenyl neopentyl phosphate, pentaerythritol diphenyl diphosphate, and ethyl pyrocatechol phosphate, as well as mixtures thereof, can also be included in the examples.

In one embodiment, the flame retardant aid may be used alone in the flame retardant of component (B) or used in a combination. With the addition of a flame retardant aid, the amount of flame retardant added can be reduced, or flame retardancy that would not be possible by using only flame retardant can be achieved. Therefore, the flame retardant aid can be appropriately used according to the type and application of the resin to which the flame retardant will be added. The particle size, melting point, viscosity, and the like of the flame retardant aid can be selected so as to achieve excellent flame retardancy effects and powder characteristics.

The amount of the flame retardant aid to be added is, for example, from 10 to 60 parts by mass in one preferred aspect of the present invention, from 15 to 50 parts by mass in another preferred aspect of the present invention, and from 15 to 45 parts by mass in yet another preferred aspect of the present invention, per 100 parts by mass of the total content of the aforementioned (B-1) and (B-2). When the amount of the flame retardant aid added is within the range described above, the mechanical strength of the molded body is excellent, surface stickiness is not generated, and a strong carbonized layer that acts to boost flame retardancy is formed, improving flame retardancy.

In some embodiments of the present invention, the resin composition may contain a resin mixture containing the flame retardant of component (B). The content ratio of the total content of the aforementioned (B-1) and (B-2) of the flame retardant of component (B) in the resin mixture is from 50 to 80 mass% in one preferred aspect of the present invention, from 55 to 75 mass% in another preferred aspect of the present invention, and from 60 to 70 mass% in yet another preferred aspect of the present invention.

The remainder of the content ratio mentioned above of the resin mixture may contain the thermoplastic resin of component (A). Furthermore, the resin mixture may contain known antioxidants and lubricants as necessary to the extent that the object of the present invention is not impaired. Specifically, the thermoplastic resin of component (A) is a polypropylene resin in one preferred aspect of the present invention, and is a homopolypropylene or propylene-ethylene copolymer (random copolymer or block copolymer) in another preferred aspect of the present invention.

Examples of the antioxidant include antioxidants for resins, such as those selected from known phosphorus-based antioxidants, sulfur-based antioxidants, phenol-based antioxidants (for example, phosphite-based antioxidants and thioether-based antioxidants such as those described in paragraphs 0015 to 0025 of JP 07-076640 A, and allyl phosphite and alkyl phosphite such as tris(2,4-di-t-butylphenyl) phosphite and trisisodecyl phosphite), and amine-based antioxidants. Examples of commercially available products include "Irganox 1010", available from BASF Japan, and "ADK STAB PEP36", available from ADEKA Corporation.

Examples of the lubricant include known lubricants such as lipids, waxes, and silicone resins; for example, those selected from what is described in paragraphs 0068 to 0073 of JP 2009-167270 A. Examples of commercially available products include "ALFLOW H-50S", available from NOF Corporation.

### Metal fiber (C)

The metal fiber of component (C) is, for example, selected from the group consisting of stainless steel (SUS) fiber, copper fiber, silver fiber, gold fiber, aluminum fiber, and brass fibers in one preferred aspect of the present invention, and may be stainless steel fiber in another preferred aspect of the present invention.

According to an embodiment of the present invention, component (C) may be a resin-applied metal fiber bundle obtained by melting a resin component containing the thermoplastic resin of component (A) on a bundle of metal fiber of which the fiber filaments are aligned in the lengthwise direction and bundled together, applying the flame retardant of component (B) in a dispersed state as necessary, and after integration occurs, cutting the metal fiber bundle into chunks of a predetermined length.

The filament diameter of the metal fiber of component (C) is from 5 to 20 µm in one preferred aspect of the present invention, from 7 to 16 µm in another preferred aspect of the present invention, and from 10 to 13 µm in yet another preferred aspect of the present invention, and may be a long fiber or a short fiber.

According to an embodiment of the present invention, when the metal fiber of component (C) is in the form of a resin-applied metal fiber fiber bundle, the metal fiber in the resin-applied metal fiber fiber bundle is component (C), and the resin component is included in component (A).

According to an embodiment of the present invention, depending on the result of application, the resin-applied metal fiber bundle described here includes: the ones in which the resin permeates to the center of the metal fiber bundle (the metal fiber bundle is impregnated with the resin), or the resin penetrates between the fiber filaments in the center of the fiber bundle (hereinafter resin-applied metal fiber bundles in such state will be referred to as "resin-impregnated metal fiber bundle"); the ones in which only the surface of the reinforcing fiber bundle is covered with resin (or "resin-coated metal fiber bundle"); and the ones somewhere in between the above two states, that is, the surface of the fiber bundle is covered with resin, and the resin permeates only the vicinity of the surface but not all the way to the center ("partial-resin-impregnated metal fiber bundle"); of these, "resin-impregnated metal fiber bundle" is preferable.

According to an embodiment of the present invention, the resin-applied metal fiber bundle can be produced by well-known production methods, such as those listed in paragraph 0043 of JP 5959183 B. The number of metal fiber filaments in the metal fiber bundle can be adjusted, for example, in the range from 100 to 30000.

In some embodiments of the present invention, the content of metal fiber in the resin-applied metal fiber bundle is from 20 to 70 mass% in one preferred aspect of the present invention, from 30 to 60 mass% in another preferred aspect of the present invention, and from 40 to 50 mass% in yet another preferred aspect of the present invention, per 100 mass% of the resin-applied metal fiber bundle. The remainder of the content ratio may be a resin component containing the thermoplastic resin of component (A); the thermoplastic resin of component (A) is a polypropylene resin in one preferred aspect of the present invention, and is a homopolypropylene or propylene-ethylene copolymer (random copolymer or block copolymer) in another preferred aspect of the present invention. The resin component containing the thermoplastic resin of component (A) may contain a resin additive such as a stabilizer, but does not contain a flame retardant such as component (B).

According to an embodiment of the present invention, the length of the resin-applied metal fiber bundle (that is, the length of the metal fiber of component (C)) is from 1 to 15 mm in a preferred aspect of the present invention, from 2 to 10 mm in another preferred aspect of the present invention, from 3 to 7 mm in yet another preferred aspect of the present invention, and from 5 to 7 mm in yet further another preferred aspect of the present invention. The diameter of the resin-applied metal fiber bundle is not limited, but may be, for example, in the range from 0.5 to 5 mm.

### Glass fiber (D)

Furthermore, the resin composition may contain glass fiber as component (D) from the perspective of, for example, rigidity improvement and strength improvement (tensile strength, flexural strength, and impact strength).

Component (D) may be a resin mixture containing glass fiber, and the content ratio of glass fiber per 100 mass% of the resin mixture is from 10 to 70 mass% in a preferred aspect of the present invention, from 20 to 65 mass% in another preferred aspect of the present invention, and from 30 to 60 mass% in yet another preferred aspect of the present invention. The remainder of the content ratio may be a resin component containing the thermoplastic resin of component (A); the thermoplastic resin of component (A) is a polypropylene resin in one preferred aspect of the present invention, and is a homopolypropylene or propylene-ethylene copolymer (random copolymer or block copolymer) in another preferred aspect of the present invention.

When the glass fiber of component (D) is a resin mixture containing component (A), the glass fiber in the resin mixture is component (C), and the resin component is included in component (A).

The filament diameter of the glass fiber of component (D) is from 9 to 20 µm in one preferred aspect of the present invention, from 10 to 17 µm in another preferred aspect of the present invention, and from 13 to 17 µm in yet another preferred aspect of the present invention, and may be a long fiber or a short fiber.

When the glass fiber of component (D) is a long fiber, resin-applied long glass fiber bundle may be used; such resin-applied long glass fiber fiber bundle can be obtained by applying a resin component containing the thermoplastic resin of component (A) in a molten state on a bundle of long glass fiber of which the fiber filaments are aligned in the lengthwise direction and bundled together, and cutting the bundle into chunks of a predetermined length after integration. The resin component containing the thermoplastic resin of component (A) may contain a resin additive such as a stabilizer, but does not contain a flame retardant such as component (B). When the glass fiber of component (D) is in the form of a resin-applied long glass fiber fiber bundle, the glass fiber in the resin-applied long glass fiber fiber bundle is component (D), and the resin component is included in component (A).

Same as the description in "Metal Fiber (C)" above, the resin-applied long glass fiber bundle here also include different ones, "resin-impregnated long glass fiber bundle", "resin-coated long glass fiber bundle", and "partial-resin-impregnated long glass fiber bundle", depending on the result of application; of which, "resin-impregnated long glass fiber bundle" may be preferably used.

The number of filaments of glass fiber in the long glass fiber bundle can be adjusted, for example, in the range from 500 to 10000, and can be produced in accordance with "production methods of resin-applied metal fiber bundle" described in "Metal Fiber (C)" above.

According to an embodiment of the present invention, the length of the resin-applied long glass fiber bundle (that is, the length of the glass fiber of component (D)) is from 5 to 50 mm in a preferred aspect of the present invention, from 7 to 25 mm in another preferred aspect of the invention, and from 9 to 15 mm in yet another preferred aspect of the invention. The diameter of the resin-applied fiber bundle is not limited, but can be, for example, in the range from 0.5 to 5 mm.

According to an embodiment of the present invention, when the glass fiber of component (D) is a short fiber, the glass fiber of component (D) is a short glass fiber having a length from 1 to 4 mm in a preferred aspect of the present invention, and is a short glass fiber having a length from 2 to 3 mm in another preferred aspect of the present invention. The glass short fiber may be, for example, chopped strands, or a surface-treated fiber.

According to an embodiment of the present invention, when the glass fiber of component (D) is a short fiber, a resin mixture in which glass short fiber is dispersed in a resin component containing the thermoplastic resin of component (A) may be used, and the resin component may contain a resin additive such as a stabilizer or the flame retardant of component (B). In some embodiments, the glass fiber of component (D) may contain both the aforementioned long fiber (resin-applied long glass fiber fiber bundle) and a short glass fiber.

In some embodiments, component (D) may be a short glass fiber from the perspective of electromagnetic wave shielding property. By using a short glass fiber as component (D), contact between the metal fiber filaments is not interfered, and electromagnetic wave shielding property of the molded body containing the resin composition according to an embodiment of the present invention can be enhanced.

### Carbonization accelerator (E)

According to an embodiment of the present invention, examples of the carbonization accelerator include: organometallic complex compounds such as ferrocene; metal hydroxides such as cobalt hydroxide, magnesium hydroxide, and aluminum hydroxide; alkaline earth metal borates such as magnesium borate and calcium magnesium borate; metal oxides such as manganese borate, zinc borate, zinc metaborate, antimony trioxide, alumina trihydrate, magnesium bicarbonate, aluminum oxide, magnesium oxide, silicon oxide, zirconium oxide, vanadium oxide, molybdenum oxide, nickel oxide, manganese oxide, titanium oxide, silicon oxide, cobalt oxide, and zinc oxide; aluminosilicates such as zeolite; silicate type solid acids such as silica titania; metal phosphates such as calcium phosphate, magnesium phosphate, aluminum phosphate, and zinc phosphate; and clay minerals such as hydrotalcite, kaolinite, sericite, pyrophyllite, bentonite and talc.

Among these, from the perspective of effectiveness as a carbonization accelerator, the carbonization accelerator is, for example, at least one selected from the group consisting of magnesium bicarbonate, zinc oxide, titanium oxide, magnesium oxide, and silicon oxide in one preferred aspect of the present invention, and is zinc oxide in another preferred aspect of the present invention. Optionally, any of the other carbonization accelerators described above may also be included.

In some embodiments, the resin composition may contain carbon black. Examples of the carbon black include known furnace black, channel black, acetylene black, and ketjen black. The carbon black contained in the resin composition according to an embodiment of the present invention may be a resin mixture containing carbon black (master batch), in which the content ratio of carbon black is from 0.01 to 40 mass% in a preferred aspect of the present invention, and from 0.01 to 30 mass% in another preferred aspect of the present invention, per 100 mass% of the resin mixture. The remainder of the content ratio may be a resin component containing the thermoplastic resin of component (A), and the thermoplastic resin of component (A) may be preferably, for example, a polypropylene resin, a polyethylene resin, or a mixture of polypropylene resin and polyethylene resin.

### Additional component

In some embodiments, the resin composition may contain a heat stabilizer, a lubricant, a light stabilizer, an antioxidant, a colorant, a release agent, and the like to the extent that the problems that the present invention aims to address can be solved.

According to some embodiments of the present invention, the resin composition may be prepared, for example, using a mixer such as a tumbler mixer, a Henschel mixer, a ribbon mixer, or a kneader for components other than component (C) and component (D). After pre-mixing components other than component (C) and component (D) using the mixer mentioned above, the resin composition can be prepared by adding component (C) and component (D) to the mixture and applying a method such as: kneading the mixture with an extruder such as a single-screw or a twin-screw extruder to prepare pallets, or melting and kneading the mixture with a kneader such as a heated roller or a Banbury mixer.

### Resin molded body

A resin molded body according to some embodiments of the present invention will be described below.

In an exemplary first embodiment, the resin molded body is a molded body obtained from a resin composition containing components (A) to (C) described above (not containing component (D) and component (E)), wherein the resin molded body contains from 15 to 30 mass% of the flame retardant (B) and from 2.5 to 7.5 mass% of the metal fiber (C), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in the following (I) to (IV).
(I) A thickness of the resin molded body is from 1.5 to 8.0 mm.
(II) The resin molded body self-extinguishes within five minutes after the completion of a burning test using burning test method E as described below.
(III) The resin molded body does not have a hole after being subjected to a burning test using burning test method E as described below.
(IV) The resin molded body has an electromagnetic wave shielding property of more than 30 dB using a KEC method electric field in a frequency range from 1 to 100 MHz.

Burning test method E: A plaque (150 × 150 × 2.0 mm) made of the molded body described above is used. A 200 mm-long flame is applied from above the plaque directly onto the center of the plaque for 130 seconds. The distance from the flame contact position on the plaque to the burner mouth is 150 mm.

According to an embodiment of the present invention, the resin molded body has a determination result of V-0 or V-1 in a burning test using the UL 94 V test method on a test piece having a thickness of 1.5 mm, and has a determination result of V-0 in a preferred aspect of the present invention.

The size and shape of the resin molded body can be appropriately adjusted according to the application within a range that satisfies the following requirement (I). The resin molded body has a thickness from 1.5 to 8.0 mm in one aspect of the present invention, from 2.0 to 6.0 mm in a preferred aspect of the present invention, and from 2.0 to 4.0 mm in another preferred aspect of the present invention (requirement (I)).

The resin molded body has self-extinguishing property in which the resin molded body self-extinguishes within two minutes after the completion of a burning test using the aforementioned burning test method E without applying fire extinguishing treatment from the outside (requirement (II)). "Self-extinguishing property" refers to the property of an object in which the object burns in a flame when brought in contact with the flame but extinguishes itself within a certain period of time when moved away from the flame. According to some embodiments of the present invention, the resin molded body may have self-extinguishing property in which the resin molded body self-extinguishes within two minutes after the completion of a burning test using, in addition to the aforementioned method E, any one or more of the burning test methods A to D described below.

Among the burning test methods A to E of the present invention: method A has the most moderate burning conditions; method B and method C, in the order of increasing intensity of burning conditions, have relatively intense burning conditions; method D and method E have intense burning conditions.

Burning test method A: A plaque (150 × 150 × 2.0 mm) made of the molded body described above is used. A 20 mm-long flame according to UL 94 is applied from below the plaque directly onto the center of the plaque for 130 seconds. The distance from the flame contact position on the plaque to the burner mouth is 10 mm.

Burning test method B: A plaque (150 × 150 × 2.0 mm) made of the molded body described above is used. A 38 mm-long flame according to UL 94 is applied from below the plaque directly onto the center of the plaque for 130 seconds. The distance from the flame contact position on the plaque to the burner mouth is 20 mm.

Burning test method C: A plaque (150 × 150 × 2.0 mm) made of the molded body described above is used.

A 125 mm-long flame according to UL 94 is applied from below the plaque directly onto the center of the plaque for 130 seconds. The distance from the flame contact position on the plaque to the burner mouth is 100 mm.

Burning test method D: A plaque (150 × 150 × 2.0 mm) made of the molded body described above is used. A 125 mm-long flame according to UL 94 is applied from below the plaque directly onto the center of the plaque for 130 seconds. The distance from the flame contact position on the plaque to the burner mouth is 40 mm.

The various burning test methods are based on the self-flammability tests described in the European ECE-R100, and the resin molded body according to an embodiment of the present invention having self-extinguishing property in the various burning test methods described above can satisfy the European ECE-R100 regulation.

Furthermore, after a burning test using the burning test method E described above, the molded body of the resin molded body, or specifically, the portion of the surface of the molded body being burned, is not melted by the heat of burning which leads to hole formation (no hole formation) (requirement (III)). The "hole" here refers to a through hole that penetrates from the burned surface of the molded body all the way through along the thickness direction of the molded body, not including holes with a maximum diameter of 3 mm or less, blind holes, or dents. In one embodiment, it is preferable that there is no hole formation found in the molded body after a burning test using, in addition to the aforementioned method E, any one or more of the burning test methods A to D described above.

In an exemplary second embodiment, the resin molded body is a molded body or resin molded body obtained from a resin composition containing components (A) to (D) described above (not containing component (E)), wherein the resin molded body contains from 15 to 30 mass% of the flame retardant (B), from 2.5 to 7.5 mass% of the metal fiber (C), and from 5 to 50 mass% of the glass fiber (D), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in the aforementioned (I) to (IV).

In an exemplary third embodiment, the resin molded body is a molded body or resin molded body obtained from a resin composition containing components (A) to (E) described above, wherein the resin molded body contains from 15 to 30 mass% of the flame retardant (B), from 2.5 to 7.5 mass% of the metal fiber (C), from 5 to 50 mass% of the glass fiber (D), and from 0.7 to 5.0 mass% of the carbonization accelerator (E), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in the aforementioned (I) to (IV).

Furthermore, in another exemplary embodiment, the second embodiment and the third embodiment may satisfy the requirements (V) and (VI) below, in addition to the requirements (I) to (IV) described above.

(V) A total calorific value measured by a heat generation test using a cone calorimeter in accordance with the method described below is 8 MJ/m² or less after 130 seconds from the start of heating.

(VI) When measuring the total calorific value by a heat generation test using a cone calorimeter in accordance with the method described below, no hole is formed on the aluminum foil covering the aforementioned self-extinguishing resin molded body after 5 minutes from the start of heating.

Heat generation test using a cone calorimeter: based on ISO5660-1, a molded body in the shape of a plaque having a size of 100 mm × 100 mm and a thickness of 2.0 mm with all surfaces covered with aluminum foil (having a thickness of 12 µm) except for the surface to be heated is used as the sample, and heating is performed for 5 minutes at a radiant heat intensity of 50 kW/m². A cone calorimeter C4 (available from Toyo Seiki Seisaku-sho, Ltd.), for example, can be used as the test device.

Requirement (V) is a total calorific value of 8 MJ/m² or less after 130 seconds from the start of heating in one preferred aspect of the present invention, and is a total calorific value of 7.5 MJ/m² or less after 130 seconds from the start of heating in another preferred aspect of the present invention.

The "hole" in requirement (VI) refers to a through hole that penetrates the aluminum foil all the way through along the thickness direction, not including holes with a maximum diameter of 3 mm or less, blind holes, or dents. In the heat generation test using a cone calorimeter, because all surfaces of the sample are covered with aluminum foil except for the surface to be heated, when heat is transferred mainly to the covered portion of the surface opposite the surface to be heated, and the temperature exceeds the melting point of aluminum, which is approximately 660°C, the aluminum foil melts, and a hole is formed.

According to some embodiments of the present invention, the resin molded body exhibits electromagnetic wave shielding property of more than 30 dB using a KEC method electric field in a frequency range from 1 to 100 MHz as measured using a plaque made of the molded body (150 mm of length, 150 mm of width, 2.0 mm of thickness) (requirement (IV)). The method of measuring electromagnetic wave shielding property can be, for example, the ones described in the examples.

According to some embodiments of the present invention, as long as the contents of components (B), (C), and (D) of the molded body is within the following rages, the resin molded body may be one using a resin mixture (compound), such as a master batch (MB), containing a resin component containing any one or more of components (B), (C), and (D) as well as the thermoplastic resin of component (A).

The resin molded body containing components (A) to (C) (not containing components (D) and (E)) contains from 15 to 30 mass% of the flame retardant of component (B) in one embodiment of the present invention, from 17 to 28 mass% in a preferred aspect of the present invention, from 18.5 to 25 mass% in another preferred aspect of the present invention, and from 19 to 25 mass% in yet another preferred aspect of the present invention. In another embodiment, the resin molded body contains from 2.5 to 7.5 mass% of the metal fiber of component (C), from 2.5 to 7.0 mass% in one preferred aspect of the present invention, from 2.5 to 6.0 mass% in another preferred aspect of the present invention, from 3.0 to 5.0 mass% in yet another preferred aspect of the present invention, and from 3.0 to 4.5 mass% in further yet another preferred aspect of the present invention. The remaining mass percentage is component (A), with which the total mass percentage is 100.

Further, the resin molded body containing components (A) to (D) (not containing component (E)) contains from 15 to 30 mass% of the flame retardant of component (B) in one embodiment of the present invention, from 17 to 28 mass% in a preferred aspect of the present invention, from 18.5 to 25 mass% in another preferred aspect of the present invention, and from 19 to 25 mass% in yet another preferred aspect of the present invention. In another embodiment, the resin molded body contains from 2.5 to 7.5 mass% of the metal fiber of component (C), from 2.5 to 7.0 mass% in one preferred aspect of the present invention, from 2.5 to 6.0 mass% in another preferred aspect of the present invention, from 3.0 to 5.0 mass% in yet another preferred aspect of the present invention, and from 3.0 to 4.5 mass% in further yet another preferred aspect of the present invention. The resin molded body contains from 5 to 50 mass% of the glass fiber of component (D) in yet another embodiment, from 10 to 45 mass% in one preferred aspect of the present invention, and from 20 to 40 mass% in another preferred aspect of the present invention. The remaining mass percentage is component (A), with which the total mass percentage is 100.

Further, the resin molded body containing components (A) to (E) contains from 15 to 30 mass% of the flame retardant of component (B) in one embodiment of the present invention, from 17 to 28 mass% in a preferred aspect of the present invention, from 18.5 to 25 mass% in another preferred aspect of the present invention, and from 19 to 25 mass% in yet another preferred aspect of the present invention. In another embodiment, the resin molded body contains from 2.5 to 7.5 mass% of the metal fiber of component (C), from 2.5 to 7.0 mass% in one preferred aspect of the present invention, from 2.5 to 6.0 mass% in another preferred aspect of the present invention, from 3.0 to 5.0 mass% in yet another preferred aspect of the present invention, and from 3.0 to 4.5 mass% in further yet another preferred aspect of the present invention. The resin molded body contains from 5 to 50 mass% of the glass fiber of component (D) in yet another embodiment, from 10 to 45 mass% in one preferred aspect of the present invention, and from 20 to 40 mass% in another preferred aspect of the present invention. The resin molded body contains from 0.7 to 5.0 mass% of the carbonization accelerator of component (E) in yet another embodiment, from 0.7 to 4.0 mass% in a preferred aspect of the present invention, and from 0.8 to 3.5 mass% in another preferred aspect of the present invention. The remaining mass percentage is component (A), with which the total mass percentage is 100.

The amount of the carbonization accelerator to be added may be from 1 to 30 parts by mass with respect to 100 parts by mass of the total content of the aforementioned (B-1) and (B-2) according to another embodiment of the present invention, from 0.5 to 10 parts by mass in another preferred aspect of the present invention, from 0.5 to 6 parts by mass in yet another preferred aspect of the present invention, and from 2 to 5 parts by mass in yet further another preferred aspect of the present invention. When the amount of the carbonization accelerator to be added is within the range described above, good flame retardancy effect, stable extrusion during molding, favorable mechanical properties of the molded body, and good flame retardancy can be achieved.

The content ratio of component (E) in the total amount of the glass fiber of component (D) and the carbonization accelerator of component (E), calculated as [(E)/((D) + (E)) × 100], is from 2 to 13 mass% according to some embodiments of the present invention, and is from 2.5 to 10 mass% in another preferred aspect of the present invention.

The content ratio of component (E) in the total amount of the polyolefin resin of component (A), the phosphorus-based flame retardant of component (B), and the carbonization accelerator of component (E), calculated as [(E)/((A) + (B) + (E)) × 100], is from 1 to 8 mass% according to some embodiments of the present invention, from 1 to 6 mass% in another preferred aspect of the present invention, and from 3.1 to 6 mass% in yet another preferred aspect of the present invention.

Further, the resin molded body containing components (A) to (D) and carbon black (not containing component (E)) contains from 15 to 30 mass% of the flame retardant of component (B) in one embodiment of the present invention, from 17 to 28 mass% in a preferred aspect of the present invention, from 18.5 to 25 mass% in another preferred aspect of the present invention, and from 19 to 25 mass% in yet another preferred aspect of the present invention. In another embodiment, the resin molded body contains from 2.5 to 7.5 mass% of the metal fiber of component (C), from 2.5 to 7.0 mass% in one preferred aspect of the present invention, from 2.5 to 6.0 mass% in another preferred aspect of the present invention, from 3.0 to 5.0 mass% in yet another preferred aspect of the present invention, and from 3.0 to 4.5 mass% in further yet another preferred aspect of the present invention. The resin molded body contains from 0 to 50 mass% of the glass fiber of component (D) in yet another embodiment of the present invention, from 5 to 45 mass% in one preferred aspect of the present invention, from 10 to 40 mass% in another preferred aspect of the present invention, and from 20 to 40 mass% in yet another preferred aspect of the present invention. The resin molded body contains from 0.03 to 3 mass% of carbon black in yet another embodiment of the present invention, from 0.1 to 1 mass% in one preferred aspect of the present invention, and from 0.2 to 0.7 mass% in another preferred aspect of the present invention. The remaining mass percentage is component (A), with which the total mass percentage is 100.

According to some embodiments of the present invention, the content ratio (mass%) of component (B) with respect to the total content of component (A) and component (B) in the resin molded body, which can be calculated as the formula (B)/[(A) + (B)] × 100, is from 18 to 40 mass% in one preferred aspect of the present invention, from 20 to 38 mass% in another preferred aspect of the present invention, from 23 to 35 mass% in yet another preferred aspect of the present invention, and from 28 to 30 mass% in yet further another preferred aspect of the present invention.

According to some embodiments of the present invention, the content ratio (mass%) of component (B) with respect to the total content of component (A), component (C), and component (D) in the resin molded body, which can be calculated as the formula (B)/[(A) + (C) + (D)] × 100, is from 23 to 40 mass% in one preferred aspect of the present invention, from 23 to 30 mass% in another preferred aspect of the present invention, and from 23 to 25 mass% in yet another preferred aspect of the present invention.

According to some embodiments of the present invention, the resin molded body can be molded into various molded bodies using the resin composition by known techniques, such as injection molding, extrusion molding, vacuum forming, profile molding, foaming molding, injection press molding, press molding, blow molding, and gas injection molding. For example, from the perspective of better enjoying the advantages of an embodiment of the present invention as described above, the resin molded body can be molded into various molded bodies by injection molding.

Note that the configurations, combinations thereof, and the like in each embodiment of the present invention are examples, and various additions, omissions, substitutions, and other changes may be made as appropriate without departing from the spirit of the present invention. The present invention is not limited by the embodiments and is limited only by the claims.

### Examples

The following polyolefin resins (A1) to (A6) were used as component (A).
- (A1) Homopolypropylene, MFR (melt flow rate) 7, product name "PM600A", available from SunAllomer. Ltd.
- (A3) High-flow homopolypropylene, MFR 70, product name "PMB02A", available from SunAllomer. Ltd.
- (A5) High-flow propylene-ethylene block copolymer, MFR 60, product name "PMB60A", available from SunAllomer. Ltd.
- (A6) Maleic anhydride-modified polypropylene, MFR 10 (190°C x 0.325 kg), product name "OREVAC CA100", available from Arkema K.K.
- (A7) Propylene-ethylene random copolymer, MFR 25, product name "PM921V", available from SunAllomer. Ltd.

The following were used as component (B).
- (B-1) Phosphorus-based flame retardant, product name "FP-2500S", available from ADEKA Corporation
- (B-2) Phosphorus-based flame retardant, product name "FP-2100JC", available from ADEKA Corporation
- Resin mixture containing phosphorus-based flame retardant (B-1) prepared according to Production Example 11
   Component (C): Resin-impregnated long stainless fiber bundle prepared according to Production Example 12
   Component (D): Chopped glass fiber (ECS03T-480, available from Nippon Electric Glass Co., Ltd.), average filament diameter is 13 µm, average length is 3 mm
   Component (E): Zinc Oxide, Zinc Oxide II, available from Sakai Chemical Industry Co., Ltd.

The following were used as additional components.
- Chopped carbon fiber (HT C413, available from Teijin Limited), average filament diameter is 7 µm, average length is 6 mm
- Carbon black master batch (hereinafter referred to as "CBMB"), product name "EPP-K-22771", available from Polycol Industry Co., Ltd. (containing 30 mass% of carbon black, the remainder of the content ratio being a mixture of polypropylene and polyethylene)
- Stabilizer 1, product name "Irganox1010", available from BASF Japan
- Stabilizer 2, product name "ADK STAB PEP36", available from ADEKA Corporation
- Lubricant, product name "ALFLOW H-50S", available from NOF Corporation. (ethylene bis stearamide)

The methods for measuring the evaluation items were as follows.

### (1) MFR (g/10 min)

Measured at a temperature of 230°C and a load of 2.16 kg in accordance with ISO 1133.

### (2) Tensile strength (MPa)

Measured in accordance with ISO 527.

### (3) Flexural strength (MPa)

Measured in accordance with ISO 178.

### (4) Flexural modulus (MPa)

Measured in accordance with ISO 178.

### (5) Charpy impact strength (kJ/m²)

Notched Charpy impact strength was measured in accordance with ISO 179/1eA.

### Flame retardancy

Test pieces having a thickness of 1.5 mm made of the resin compositions of Examples and Comparative Examples were tested in a UL 94 vertical burning test (V test) for bar specimens (125 mm × 13 mm x 1.5 mm) using a 20 mm flame.

### Electromagnetic wave shielding property

Electromagnetic wave shielding property in the frequency range from 1 to 100 MHz were evaluated in accordance with the KEC method (electric field) using molded bodies (150 mm of length, 150 mm of width, 2.0 mm of thickness).

### Evaluation of self-extinguishing property and hole formation by plaque burning test

Molded bodies in a shape of a plaque having a size of 150 mm x 150 mm and a thickness of 2.0 mm were used as samples. Within two minutes after the completion of the burning test by the above burning test method E, resin molded bodies according to an embodiment of the present invention which self-extinguished were evaluated as "(Self-extinguishing property) Present", while resin molded bodies according to an embodiment of the present invention which did not self-extinguish were evaluated as "(Self-extinguishing property) Absent".

In addition, after the resin molded bodies self-extinguished, or after fire was extinguished by blocking the air (oxygen) via, for example, covering the resin molded bodies with a lid, the resin molded bodies having a through hole with a maximum diameter of more than 3 mm were evaluated as "(Hole) Present", while the resin molded bodies with no through holes were evaluated as "(Hole) Absent". Note that, the "-" in the table means that in the UL 94 burning test, the test piece was evaluated as "not V", which is outside of the standards of UL 94, and thus the plaque burning test could not be performed.

### Total calorific value

The total calorific value was measured using samples of molded body in the shape of a plaque having a size of 100 mm x 100 mm and a thickness of 2.0 mm in accordance with ISO 5660-1 by a cone calorimeter C4 (available from Toyo Seiki Seisaku-sho, Ltd.) as a test device. Heating was performed for 5 minutes at a radiant heat intensity of 50 kW/m². All surfaces of a sample were covered with aluminum foil (thickness: 12 µm) except for the surface to be heated. The results of the total calorific value [MJ/m²] and the presence or absence of hole formation on the aluminum foil (by visual observation) after 130 secs from the start of heating are shown in Table 4.

### Production Examples 1 to 10 (production of fiber-containing polypropylene-based flame-retardant compound)

Resin mixtures containing the thermoplastic resin of component (A), the flame retardant of component (B), zinc oxide of component (E), carbon black (master batch), and other additives as shown in Table 1 were mixed in a tumbler in accordance with the formulations as shown in Table 1, and then fed from the hopper of a twin-screw extruder (TEX30α, available from the Japan Steel Works, Ltd., at 230°C). Then, the chopped glass fiber of component (D) and chopped carbon fiber were fed from the side feeder. After melt-kneading and shaping, the resin mixtures shown in Table 1 (as pellets having a diameter of 3.0 mm and a length of 3.0 mm) were obtained.

**[Table 1]**

| | | | Production Example 1 | Production Example 2 | Production Example 3 | Production Example 4 | Production Example 5 | Production Example 6 | Production Example 7 | Production Example 8 | Production Example 9 | Production Example 10 |
|---|---|---|---|---|---|---|---|---|---|---|---|---|
| Fiber-containing PP-based Flame-retardant Compound (parts by mass) | (A) PP Resin | (A1) PP Resin | 15 | 15 | 15 | 15 | 15 | 15 | 15 | 15 | 15 | 15 |
| | | (A3) PP Resin | 54 | 54 | 54 | 54 | 54 | 54 | 54 | 54 | 54 | 50 |
| | | (A5) PP Resin | 30.0 | 21.0 | 21.0 | 25.8 | 25.5 | 21 | 21 | 30.0 | 30.0 | 30.0 |
| | | (A6) Acid-modified PP | 1 | 10 | 10 | 5.2 | 5.5 | 10 | 10 | 1 | 1 | 5 |
| | (B) Flame Retardant | (B-1) Flame Retardant | 46 | 40 | 43 | 44.6 | 43 | 43 | 45 | 0 | 0 | 0 |
| | | (B-2) Flame Retardant | 0 | 0 | 0 | 0 | 0 | 0 | 0 | 44 | 44 | 44 |
| | (D) Chopped Glass Fiber | | 64.1 | 40.8 | 31.3 | 48.8 | 52.5 | 0 | 0 | 64.3 | 64.3 | 64.3 |
| | (E) Zinc Oxide | | 0 | 0 | 0 | 0 | 0 | 0 | 0 | 0 | 2.1 | 7.6 |
| | Chopped Carbon Fiber | | 0 | 20.4 | 31.3 | 14.6 | 10.2 | 25.7 | 37 | 0 | 0 | 0 |
| | CBMB | | 2.1 | 1.1 | 1.2 | 1.7 | 1.6 | 1.2 | 1.3 | 2.1 | 2.1 | 2.1 |
| | Stabilizer 1 | | 0.3 | 0.3 | 0.3 | 0.3 | 0.3 | 0.3 | 0.3 | 0.3 | 0.3 | 0.3 |
| | Stabilizer 2 | | 0.2 | 0.2 | 0.2 | 0.2 | 0.2 | 0.2 | 0.2 | 0.2 | 0.2 | 0.2 |
| | Lubricant | | 1 | 1 | 1 | 1 | 1 | 1 | 1 | 1 | 1 | 1 |
| | Total (parts by mass) | | 213.7 | 203.8 | 208.2 | 211.2 | 208.8 | 171.4 | 184.8 | 212.0 | 214.0 | 219.5 |
| MFR | 230°C/2.16 kg (g/10 min) | | 8.8 | 7.7 | 6.4 | 7.0 | 7.0 | 9.3 | 5.7 | 12.0 | 10.9 | 9.0 |

### Production Example 11 (production of resin mixture containing phosphorus-based flame retardant (B-1))

30 parts by mass of component (A7), 0.20 parts by mass of stabilizer 1, 0.20 parts by mass of stabilizer 2, and 2.50 parts by mass of lubricant were dry blended, and then fed from the hopper of a twin-screw extruder (TEX30α, available from the Japan Steel Works, Ltd., at 230°C). Then, 70 parts by mass of component (B-1) was fed from the side feeder. The mixture was then melt-kneaded and shaped to obtain a resin mixture containing the phosphorus-based flame retardant (B-1) shown in Table 2 (as pellets having a diameter of 3.0 mm and a length of 3.0 mm).

### Production Example 12 (production of resin-impregnated stainless fiber bundle)

A stainless fiber bundle (approximately 7000 filaments of fiber) of component (C) was passed through a crosshead die. A blend of component (A5):component (A6):stabilizer 1:stabilizer 2 = 48.0:1.50:0.25:0.25 (parts by mass) was melted and fed. The stainless fiber bundle was impregnated with the blend, and a resin-impregnated long stainless fiber bundle was obtained. Thereafter, the fiber bundle was shaped (diameter: 3.5 mm) by a shaping nozzle at the outlet of the crosshead die and a shaping roll, and cut to 7 mm by a pelletizer to obtain a resin-impregnated fiber bundle (as pellets) containing 50 mass% of stainless steel fiber (C). When the resin-impregnated fiber bundle obtained in this manner was cut, it was confirmed that the stainless steel fiber filaments were almost parallel to the length direction, and the center of the fiber bundle was impregnated with the resin.

### Examples 1 and 2

The fiber-containing polypropylene-based flame-retardant compound of Production Example 1 and the resin-impregnated fiber bundle of Production Example 12 were mixed in a tumbler in accordance with the formulations shown in Table 2 and then charged into an injection molding machine (FANUC ROBOSHOT α-S150iA, available from FANUC Corporation, with the mold at 50°C and molding temperature at 220°C) to obtain resin molded bodies.

### Example 3

Component (A), the resin mixture containing the flame retardant (B) of Production Example 11, and the resin-impregnated long metal fiber bundle of Production Example 12 were mixed in a tumbler in accordance with the formulation shown in Table 2 to obtain a resin molded body by the same production method as described in Example 1.

### Comparative Example 1

The fiber-containing polypropylene-based flame-retardant compound of Production Example 1 and the resin-impregnated fiber bundle of Production Example 12 were mixed in a tumbler in accordance with the formulation shown in Table 2 to obtain a resin molded body by the same production method as described in Example 1.

### Comparative Examples 2 to 8

The fiber-containing polypropylene-based flame-retardant compounds of Production Examples 1 to 7 were charged into an injection molding injection molding machine (FANUC ROBOSHOT α-S150iA, available from FANUC Corporation, with the mold at 50°C and molding temperature at 220°C) to obtain resin molded bodies. The evaluation results of Examples 1 to 3 and Comparative Examples 1 to 8 are shown in Table 2.

**[Table 2]**

| | | | | Example 1 | Example 2 | Example 3 | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|---|---|---|
| Molded Body (parts by mass) | (A3) PP Resin | | | | | 61.4 | | | | | | | | |
| | Resin Mixture Containing Phosphorus-based Flame Retardant (B-1) | | | | | 28.6 | | | | | | | | |
| | Resin-impregnated Long Stainless Fiber Bundle (containing 50 mass% of stainless fiber (C)) | | | 8 | 12 | 10 | 16 | | | | | | | |
| | Fiber-containing PP-based Flame-retardant Compound | Production Example 1 | | 92 | 88 | | 84 | | | | | | | 100 |
| | | Production Example 2 | | | | | | 100 | | | | | | |
| | | Production Example 3 | | | | | | | 100 | | | | | |
| | | Production Example 4 | | | | | | | | 100 | | | | |
| | | Production Example 5 | | | | | | | | | 100 | | | |
| | | Production Example 6 | | | | | | | | | | 100 | | |
| | | Production Example 7 | | | | | | | | | | | 100 | |
| | Total (mass%) | | | 100 | 100 | 100 | 100 | 100 | 100 | 100 | 100 | 100 | 100 | 100 |
| Content of (B) in Molded Body | | | mass% | 19.8 | 18.9 | 20.0 | 18.1 | 19.6 | 20.7 | 21.1 | 20.6 | 25.1 | 24.4 | 21.5 |
| Conductive Fiber in Molded Body | | Type | | SF | SF | SF | SF | CF | CF | CF | CF | CF | CF | - |
| | | Content | mass% | 4 | 6 | 5 | 8 | 10 | 15 | 7 | 5 | 15 | 20 | 0 |
| Content of (D) in Molded Body | | | mass% | 28 | 26 | 0 | 25 | 20 | 15 | 23 | 25 | 0 | 0 | 30 |
| (B)/[(A) + (B)] x 100 | | | mass% | 28.9 | 28.0 | 21.1 | 27.0 | 28.6 | 30.1 | 30.8 | 30.1 | 30.1 | 31.0 | 31.5 |
| (B)/[(A) + (C) + (D)] x 100 | | | mass% | 24.7 | 23.3 | 25.0 | 22.0 | 24.4 | 26.1 | 26.7 | 25.9 | 33.5 | 32.3 | 27.4 |
| Mechanical Property | Tensile Strength | | MPa | 74 | 74 | 40 | 74 | 70 | 60 | 50 | 45 | 44 | 48 | 85 |
| | Flexural Strength | | MPa | 120 | 120 | 60 | 120 | 130 | 110 | 80 | 75 | 71 | 78 | 140 |
| | Flexural Modulus | | MPa | 7300 | 7300 | 5000 | 7300 | 12800 | 14500 | 11800 | 10500 | 10300 | 13500 | 8720 |
| | Charpy Impact Strength | | kJ/m² | 8.0 | 7.9 | 5.0 | 7.0 | 8.3 | 6.7 | 6.0 | 6.0 | 4.9 | 5.0 | 10.1 |
| | Specific Strength (Tensile) | | kN·m/kg | 56 | 56 | 38 | 55 | 56 | 48 | 39 | 35 | 39 | 41 | 65 |
| | Specific Strength (Flexural) | | kN·m/kg | 91 | 90 | 57 | 89 | 104 | 88 | 63 | 59 | 63 | 67 | 108 |
| | Specific Modulus | | kN·m/kg | 5530 | 5490 | 4760 | 5410 | 10240 | 11600 | 9290 | 8270 | 9120 | 11640 | 6710 |
| Flammability | UL94/1.5 mmt | | - | V-0 | V-1 | V-0 | Not V | Not V | Not V | V-0 | V-0 | Not V | Not V | V-0 |
| Density | | | g/cm³ | 1.32 | 1.33 | 1.05 | 1.35 | 1.25 | 1.25 | 1.27 | 1.27 | 1.13 | 1.16 | 1.30 |
| Molded Body Burning Test | Method A/2.0 mmt | | Hole Formation | Absent | Absent | Absent | Absent | Absent | Absent | Absent | Absent | Absent | Absent | Absent |
| | | | Self-digesting Property | Present | Present | Present | Absent | Absent | Absent | Absent | Absent | Absent | Absent | Present |
| Electromagnetic Wave Shielding Property | | 1 MHz | dB | >50 | >60 | >60 | >60 | >50 | >50 | 48 | 25 | >60 | >60 | - |
| | | 10 MHz | dB | 45 | 60 | 55 | >60 | 45 | >50 | 35 | 15 | 59 | >60 | - |
| | | 100 MHz | dB | 40 | 45 | 50 | 50 | 30 | 40 | 20 | 10 | 45 | 50 | - |

| | | | | | | | | | | | | | | |
|---|---|---|---|---|---|---|---|---|---|---|---|---|---|---|
| 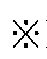 In Table 2, CF means carbon fiber and SF means stainless fiber. | | | | | | | | | | | | | | |

Examples 1 to 3 obtained resin molded bodies having high mechanical strength in addition to excellent self-extinguishing property, flame retardancy, and electromagnetic wave shielding property. Of which, Examples 1 and 2 obtained resin molded bodies with high specific tensile strength (tensile strength/density), specific flexural strength (flexural strength/density), and specific modulus (flexural modulus/density). Furthermore, Example 3 obtained a resin molded body that has self-extinguishing property, flame retardancy, and electromagnetic wave shielding property equivalent to those of resin molded bodies of Examples 1 and 2 but was lighter, or less dense, than resin molded bodies of Examples 1 and 2 which contained glass fiber.

### Examples 4 to 6

The fiber-containing polypropylene-based flame-retardant compounds of Production Examples 8 to 10 shown in Table 1 and the resin-impregnated fiber bundle of Production Example 12 were mixed in a tumbler in accordance with the formulations shown in Table 3 and then charged into an injection molding machine (FANUC ROBOSHOT α-S150iA, available from FANUC Corporation, with the mold at 50°C and molding temperature at 220°C) to obtain resin molded bodies. The evaluation results are shown in Table 3.

**[Table 3]**

| | | | | Example 4 | Example 5 | Example 6 |
|---|---|---|---|---|---|---|
| Molded Body (parts by mass) | Resin-impregnated Long Stainless Fiber Bundle (containing 50 mass% of stainless fiber (C)) | | | 10 | 10 | 10 |
| | Fiber-containing PP-based Flame-retardant Compound | Production Example 8 | | 90 | | |
| | | Production Example 9 | | | 90 | |
| | | Production Example 10 | | | | 90 |
| | Total (mass%) | | | 100 | 100 | 100 |
| Content of (B) in Molded Body | | | mass% | 18.7 | 18.5 | 18.0 |
| Conductive Fiber in Molded Body | | Type | | SF | SF | SF |
| | | Content | mass% | 5 | 5 | 5 |
| Content of (D) in Molded Body | | | mass% | 27.3 | 27.1 | 26.4 |
| Content of (E) in molded body | | | mass% | - | 0.87 | 3.11 |
| (B)/[(A) + (B)] × 100 | | | mass% | 30.6 | 30.6 | 30.6 |
| (B)/[(A) + (C) + (D)] × 100 | | | mass% | 25.0 | 25.0 | 24.9 |
| (E)/[(D) + (E)] × 100 | | | mass% | - | 3.12 | 10.54 |
| (E)/[(A) + (B) + (E)] × 100 | | | mass% | - | 1.42 | 5.00 |
| Mechanical Property | Tensile Strength | | MPa | 78 | 76 | 73 |
| | Flexural Strength | | MPa | 128 | 126 | 125 |
| | Flexural Modulus | | MPa | 7800 | 7900 | 8000 |
| | Charpy Impact Strength | | kJ/m² | 8.5 | 8.2 | 7.6 |
| | Specific Strength (Tensile) | | kN·m/kg | 59.1 | 57.1 | 54.5 |
| | Specific Strength (Flexural) | | kN·m/kg | 97.0 | 94.7 | 93.3 |
| | Specific Modulus | | kN·m/kg | 5910 | 5940 | 5970 |
| Flammability | UL94/1.5 mmt | | - | V-0 | V-0 | V-0 |
| Density | | | g/cm³ | 1.32 | 1.33 | 1.34 |
| Molded Body Burning Test | Method A/2.0 mmt | | Hole Formation | Absent | Absent | Absent |
| | | | Self-digesting Property | Present | Present | Present |
| Electromagnetic Wave Shielding Property | | 1 MHz | dB | >60 | >60 | >60 |
| | | 10 MHz | dB | 55 | 55 | 55 |
| | | 100 MHz | dB | 45 | 45 | 45 |

| | | | | | | |
|---|---|---|---|---|---|---|
| 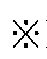 In Table 3, CF means carbon fiber and SF means stainless fiber. | | | | | | |

**[Table 4]**

| | Total Calorific Value after 130 sec from Start of Heating [MJ/m²] | Hole Formation on Aluminum Foil |
|---|---|---|
| Example 1 | 7.1 | Absent |
| Example 2 | 7.7 | Absent |
| Example 4 | 7.4 | Absent |
| Example 5 | 6.6 | Absent |
| Example 6 | 6.0 | Absent |
| Comparative Example 1 | 8.3 | Absent |
| Comparative Example 5 | 9.2 | Absent |
| Comparative Example 6 | 8.8 | Absent |
| Comparative Example 7 | 9.3 | Absent |

### Industrial Applicability

The resin molded body according to an example of the present invention has flame retardancy and self-extinguishing property that satisfy the standards for fire resistance tests, such as ECE-R100, and therefore can be used in: battery-powered electric transportation devices, such as electric vehicles, electric shuttle buses, electric trucks, electric two-wheelers, electric wheelchairs, and electric standing two-wheelers; in particular, all or part of the battery module enclosure of electric transportation devices that use built-in batteries which cannot be removed, and peripheral parts thereof (fastening parts, etc.); furthermore, a charger connector for electric vehicles, a battery capacitor holder, a battery capacitor enclosure, and an enclosure for charging stand for electric vehicles.

In addition, since the resin molded body according to an example of the present invention has electromagnetic wave shielding property, it can prevent unwanted radio waves generated from the enclosure or parts described above from becoming noise in an in-vehicle radio. Furthermore, the resin molded body according to an example of the present invention can be used in a housing or the like of an electric/electronic device other than a vehicle.

## Claims

1. A resin molded body obtained from a resin composition comprising a thermoplastic resin (A), a flame retardant (B), and a metal fiber (C), wherein the resin molded body comprises from 15 to 30 mass% of the flame retardant (B) and from 2.5 to 7.5 mass% of the metal fiber (C), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in (I) to (IV):
(I) A thickness of the resin molded body is from 1.5 to 8.0 mm;
(II) The resin molded body self-extinguishes within five minutes after the completion of a burning test using burning test method E as described below;
(III) The resin molded body does not have a hole after being subjected to a burning test using burning test method E as described below;
(IV) The resin molded body has an electromagnetic wave shielding property of more than 30 dB using a KEC method electric field in a frequency range from 1 to 100 MHz; where
Burning test method E: A plaque (150 × 150 × 2.0 mm) made of the molded body described above is used;
a 200 mm-long flame is applied from above the plaque directly onto the center of the plaque for 130 seconds, and
the distance from the flame contact position on the plaque to the burner mouth is 150 mm.

2. A resin molded body obtained from a resin composition comprising a thermoplastic resin (A), a flame retardant (B), a metal fiber (C), and a glass fiber (D), wherein the resin molded body comprises from 15 to 30 mass% of the flame retardant (B), from 2.5 to 7.5 mass% of the metal fiber (C), and from 5 to 50 mass% of the glass fiber (D), with the remainder being the component (A) to make a total of 100 mass%; the resin molded body has a determination result of V-0 or V-1 in a burning test using the UL 94 V test method on a test piece having a thickness of 1.5 mm; and the resin molded body satisfies the requirements described in (I) to (IV):
(I) A thickness of the resin molded body is from 1.5 to 8.0 mm;
(II) The resin molded body self-extinguishes within five minutes after the completion of a burning test using burning test method E as described below;
(III) The resin molded body does not have a hole after being subjected to a burning test using burning test method E as described below;
(IV) The resin molded body has an electromagnetic wave shielding property of more than 30 dB using a KEC method electric field in a frequency range from 1 to 100 MHz; where
Burning test method E: A plaque (150 × 150 × 2.0 mm) made of the molded body described above is used,
a 200 mm-long flame is applied from above the plaque directly onto the center of the plaque for 130 seconds, and
the distance from the flame contact position on the plaque to the burner mouth is 150 mm.

3. A resin molded body obtained from a resin composition comprising a thermoplastic resin (A), a flame retardant (B), a metal fiber (C), a glass fiber (D), and at least one carbonization accelerator (E) selected from the group consisting of magnesium bicarbonate, zinc oxide, titanium oxide, magnesium oxide, and silicon oxide, wherein the resin molded body comprises from 15 to 30 mass% of the flame retardant (B), from 2.5 to 7.5 mass% of the metal fiber (C), from 5 to 50 mass% of the glass fiber (D), and from 0.7 to 5.0 mass% of the carbonization accelerator (E), with the remainder being the component (A) to make a total of 100 mass%;
the resin molded body has a determination result of V-0 or V-1 in a burning test using the UL 94 V test method on a test piece having a thickness of 1.5 mm; and the resin molded body satisfies the requirements described in (I) to (IV):
(I) A thickness of the resin molded body is from 1.5 to 8.0 mm;
(II) The resin molded body self-extinguishes within five minutes after the completion of a burning test using burning test method E as described below;
(III) The resin molded body does not have a hole after being subjected to a burning test using burning test method E as described below;
(IV) The resin molded body has an electromagnetic wave shielding property of more than 30 dB using a KEC method electric field in a frequency range from 1 to 100 MHz; where
Burning test method E: A plaque (150 × 150 × 2.0 mm) made of the molded body described above is used,
a 200 mm-long flame is applied from above the plaque directly onto the center of the plaque for 130 seconds, and
the distance from the flame contact position on the plaque to the burner mouth is 150 mm.

4. The resin molded body according to claim 2 or 3, further satisfying the requirements (V) and (VI):
(V) A total calorific value measured by a heat generation test using a cone calorimeter in accordance with the method described below is 8 MJ/m² or less after 130 seconds from the start of heating;
(VI) When measuring the total calorific value by a heat generation test using a cone calorimeter in accordance with the method described below, no hole is formed on an aluminum foil covering the self-extinguishing resin molded body after 5 minutes from the start of heating; where
Heat generation test using a cone calorimeter: based on ISO5660-1, a molded body in the shape of a plaque having a size of 100 mm × 100 mm and a thickness of 2.0 mm with all surfaces covered with aluminum foil (having a thickness of 12 µm) except for the surface to be heated is used as the sample, and heating is performed for 5 minutes at a radiant heat intensity of 50 kW/m².

5. The resin molded body according to any one of claims 1 to 4, wherein the resin molded body is in the form of a resin-applied long fiber bundle, which is a metal fiber bundle or a glass fiber bundle having the thermoplastic fat of the component (A) applied in a molten state and being integrated before being cut to a length from 1 to 15 mm, the metal fiber bundle or the glass fiber bundle being a fiber bundle in which the filaments of the metal fiber of the component (C) or the glass fiber of the component (D) are aligned in the lengthwise direction and bundled together.

6. The resin molded body according to any one of claims 1 to 5, wherein the component (B) is a phosphorus-based flame retardant.

7. The resin molded body according to any one of claims 1 to 5, wherein the component (A) is a polypropylene resin.

8. The resin molded body according to any one of claims 1 to 7, wherein the resin molded body is an enclosure part or a peripheral part of a vehicle battery module.
